# EUROPEAN PATENT APPLICATION

(11) **EP 4 576 185 A2**
(43) Date of publication of application: **25.06.2025**
(21) Application number: 24210742.3
(22) Date of filing: 05.11.2024
(51) Int. Cl.: H01L 21/768, H01L 23/522, H01L 23/528, H01L 23/532

(54) **TRANSISTOR PERFORMANCE IMPROVEMENT FOR STACKED DEVICES USING SELECTIVE FRONT AND BACKSIDE CONTACT METALS**

(30) Priority: 21.12.2023 US 202318393516
(71) Applicant: INTEL Corporation, Santa Clara, CA 95054 (US)
(72) Inventor: Ramaswamy, Rahul, Portland, 97229 (US); Radosavljevic, Marko, Portland, 97229 (US); Hafez, Walid, Portland, 97229 (US); Chang, Hsu-Yu, Hillsboro, 97124 (US); Mokler, Scott, Hillsboro, 97124 (US); Shankar, Adithya, Hillsboro, 97124 (US)
(74) Representative: Goddar, Heinz J.

(57) **Abstract**

Devices, transistor structures, systems, and techniques are described herein related to selective front and backside contacts for stacked transistor devices. A transistor structure includes stacked first and second semiconductor structures with stacked first and second conductivity type source and drain structures coupled to the first and second semiconductor structures, respectively. A selective metal is on the frontside of first conductivity type source and a different metal is on the backside of the second conductivity type source. A deep via optionally having yet a different metal couples the frontside contact to backside metallization over the backside contact.

## Description

### BACKGROUND

Higher performance, lower cost, increased miniaturization, and greater density of integrated circuits (ICs) are ongoing goals of the electronics industry. To maintain the pace of increasing transistor density, for example, device dimensions must continue to shrink and/or new device structures are needed. In particular, complementary field effect transistors (CFETs) stack n-type metal oxide semiconductor (NMOS) and p-type metal oxide semiconductor (PMOS) gate-all around transistor structures. Furthermore, backside power delivery or, more generally, backside contacts to transistor source and drain structures can reduce resistance and offer other advantages including increased device density. However, deployment of GAA or nanoribbon transistors and backside contacts faces numerous difficulties including high contact resistance, limited device performance, and others. It is with respect to these and other considerations that the present improvements have been needed. Such improvements may become critical as the desire to deploy advanced transistor structures becomes even more widespread.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1A illustrates a cross-sectional side view of a stacked transistor structure including a first conductivity type device stacked over a second conductivity type device;
FIG. 1B illustrates a top-down view of the stacked transistor structure of FIG. 1A;
FIG. 1C illustrates another cross-sectional side view of the stacked transistor structure of FIG. 1A;
FIG. 2 is a flow diagram illustrating methods 200 for forming a stacked transistor structure having frontside contacts, backside contacts, and deep vias with selectable and tunable metals;
FIGS. 3, 4, 5, 6, 7, 8, 9, 10, 11, 12, 13, 14, 15, 16, 17, 18A, 18B, 19, and 20 are cross-sectional side views of stacked transistor structures evolving as the methods of FIG. 2 are practiced;
FIG. 21 illustrates exemplary systems employing stacked transistor structures having frontside contacts, backside contacts, and deep vias with selectable and tunable metals;
FIG. 22 is a functional block diagram of an electronic computing device, all in accordance with some embodiments.

### DETAILED DESCRIPTION

One or more embodiments or implementations are now described with reference to the enclosed figures. While specific configurations and arrangements are discussed, it should be understood that this is done for illustrative purposes only. Persons skilled in the relevant art will recognize that other configurations and arrangements may be employed without departing from the spirit and scope of the description. It will be apparent to those skilled in the relevant art that techniques and/or arrangements described herein may also be employed in a variety of other systems and applications other than what is described herein.

Reference is made in the following detailed description to the accompanying drawings, which form a part hereof, wherein like numerals may designate like parts throughout to indicate corresponding or analogous elements. It will be appreciated that for simplicity and/or clarity of illustration, elements illustrated in the figures have not necessarily been drawn to scale. For example, the dimensions of some of the elements may be exaggerated relative to other elements for clarity. Further, it is to be understood that other embodiments may be utilized, and structural and/or logical changes may be made without departing from the scope of claimed subject matter. It should also be noted that directions and references, for example, up, down, top, bottom, over, under, and so on, may be used to facilitate the discussion of the drawings and embodiments and are not intended to restrict the application of claimed subject matter. Therefore, the following detailed description is not to be taken in a limiting sense and the scope of claimed subject matter defined by the appended claims and their equivalents.

In the following description, numerous details are set forth. However, it will be apparent to one skilled in the art, that the present invention may be practiced without these specific details. In some instances, well-known methods and devices are shown in block diagram form, rather than in detail, to avoid obscuring the present invention. Reference throughout this specification to "an embodiment" or "one embodiment" means that a particular feature, structure, function, or characteristic described in connection with the embodiment is included in at least one embodiment of the invention. Thus, the appearances of the phrase "in an embodiment" or "in one embodiment" in various places throughout this specification are not necessarily referring to the same embodiment of the invention. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description of the invention and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items. Herein, the term "predominantly" indicates not less than 50% of a particular material or component while the term "substantially pure" indicates not less than 99% of the particular material or component and the term "pure" indicates not less than 99.9% of the particular material or component. Unless otherwise indicated, such material percentages are based on atomic percentage. Herein the term concentration is used interchangeably with material percentage and also indicates atomic percentage unless otherwise indicated.

The terms "coupled" and "connected," along with their derivatives, may be used herein to describe structural relationships between components. It should be understood that these terms are not intended as synonyms for each other. Rather, in particular embodiments, "connected" may be used to indicate that two or more elements are in direct physical or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause an effect relationship, an electrical relationship, a functional relationship, etc.).

The terms "over," "under," "between," "on", and/or the like, as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening features. The term immediately adjacent indicates such features are in direct contact. Furthermore, the terms "substantially," "close," "approximately," "near," and "about," generally refer to being within +/-10% of a target value. The term layer as used herein may include a single material or multiple materials. As used in throughout this description, and in the claims, a list of items joined by the term "at least one of" or "one or more of" can mean any combination of the listed terms. For example, the phrase "at least one of A, B or C" can mean A; B; C; A and B; A and C; B and C; or A, B and C. The terms "lateral", "laterally adjacent" and similar terms indicate two or more components are aligned along a plane orthogonal to a vertical direction of an overall structure. As used herein, the terms "monolithic", "monolithically integrated", and similar terms indicate the components of the monolithic overall structure form an indivisible whole not reasonably capable of being separated.

Devices, transistor structures, integrated circuit dies, apparatuses, systems, and techniques are described herein related to selective front and backside contact metals for stacked transistor devices.

As discussed, complementary field effect transistors (CFETs) stack n-type metal oxide semiconductor (NMOS) and p-type metal oxide semiconductor (PMOS) gate-all around transistor structures for improved device density and other advantages. In some contexts, the CFETs deploy gate-all-around (GAA) or nanoribbon transistor structures such that an upper transistor structure has an NMOS transistor structure and a lower transistor structure has a PMOS transistor structure, or vice versa. The upper and lower transistor structures are separated by an insulator such as an oxide. The components of the stacked transistor structures are substantially vertically aligned with each including a source, a drain, a semiconductor material extending between the source and drain, and a gate adjacent the semiconductor material and between the source and drain. For example, the upper and lower semiconductor materials (e.g., nanoribbons), the upper and lower source structures, the upper and lower drain structures, and the upper and lower gate structures are vertically aligned. This increases device density and offers other advantages. Furthermore, backside power delivery or, more generally, backside contacts to transistor source and drain structures offer promising architectures that increase device density (e.g., by offloading power delivery routing from the frontside to the backside), improve IR droop, and provide other advantages.

In some embodiments, a CFET includes first GAA nanoribbons or other semiconductor structures that are vertically aligned with second GAA nanoribbons or other semiconductor structures. The CFET further includes a first conductivity type (e.g., n-type) source and drain coupled to the first GAA nanoribbons or other semiconductor structures and a second conductivity type (e.g., p-type) source and drain coupled to the second GAA nanoribbons or other semiconductor structures. A first contact is on the frontside of the first conductivity type source or drain and a second contact is on the backside of the second conductivity type source or drain such that the second contact is opposite the first and second conductivity type source or drain from the first contact. A deep via is coupled to (e.g., in contact with) the first contact and extends vertically such that it is adjacent to the first contact, the first and second conductivity type sources or drains, and the second contact. The deep via contacts backside metallization to, for example, provide power delivery to the first conductivity type source. Advantageously, the first contact, the second contact, and the deep via include metals selected to improve the performance of the CFET. In some embodiments, a first contact including titanium and nitrogen (e.g., titanium nitride) contacts a frontside n-type source structure and the deep via is tungsten. In some embodiments, a first contact including titanium and nitrogen (e.g., titanium nitride) contacts a frontside n-type source structure and the deep via includes a lining that includes titanium and nitrogen (e.g., titanium nitride) and a tungsten plug. In some embodiments, a first contact including titanium and nitrogen (e.g., titanium nitride) contacts a frontside n-type source structure and a second contact including nickel or platinum contacts a backside p-type source structure. In some embodiments, a second contact that contacts a backside p-type source structure is recessed to a reduced thickness to provide strain engineering for the PMOS transistor structure of the CFET. Other combinations are available as discussed further herein below.

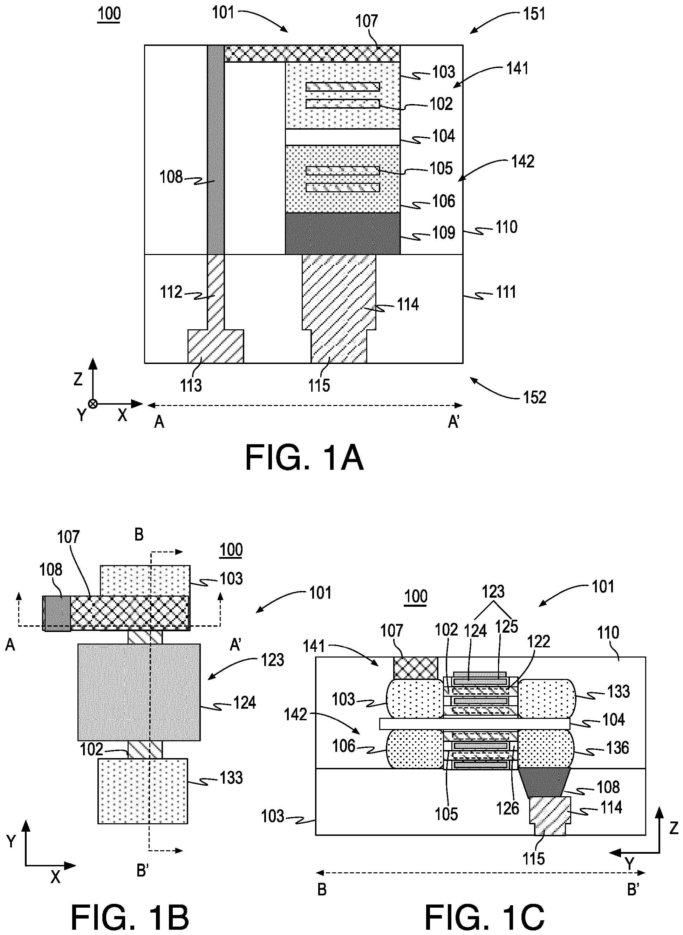

FIG. 1A illustrates a cross-sectional side view of a stacked transistor structure 100 including a first conductivity type device 141 stacked over a second conductivity type device 142, arranged in accordance with at least some implementations of the present disclosure. As shown, first conductivity type device 141 includes a first conductivity type source structure 103 and second conductivity type device 142 includes a second conductivity type source structure 106. First conductivity type source structure 103 is contacted by frontside contact 107 and second conductivity type source structure 106 is contacted by backside contact 109. Furthermore, a metal via 108 extends from contact with frontside contact 107 to backside metallization feature 112. As shown, metal via 108 extends vertically (i.e., in the z-dimension) such that a portion of metal via is laterally aligned with each of frontside contact 107, first conductivity type source structure 103, second conductivity type source structure 106, and backside contact 109.

Advantageously, using the techniques discussed herein, each of frontside contact 107, backside contact 109, and metal via 108 may include different and selective metal materials to improve the performance of stacked transistor structure 100. The details of such material are discussed further herein below.

FIG. 1B illustrates a top-down view of stacked transistor structure 100 with some components removed for the sake of illustration, and FIG. 1C illustrates another cross-sectional side view of a stacked transistor structure 100. For example, FIG. 1A illustrates a source cut taken across first conductivity type source structure 103 at A-A' in FIG. 1B and FIG. 1C illustrates a gate cut taken along a gate structure B-B' in FIG. 1B.

As shown, stacked transistor structure 100 includes a number of first semiconductor structures 102 of first conductivity type device 141 vertically aligned with a number of second semiconductor structures 105 of second conductivity type device 142. Stacked transistor structure 100 includes a CFET 101 that includes first conductivity type device 141 and second conductivity type device 142. First semiconductor structures 102 and second semiconductor structures 105 may include any suitable semiconductor material. For example, the semiconductor material may be silicon (Si), germanium (Ge), silicon germanium (SiGe), III-V materials (e.g., gallium arsenide (GaAs)), or other semiconductor materials such as transition metal dichalcogenide (TMD) materials. As used herein, the term semiconductor material indicates a material with a variable conductivity that may be manipulated for use as a channel material in a transistor.

As shown, first semiconductor structures 102 and second semiconductor structures 105 are vertically aligned. For example, first semiconductor structures 102 and second semiconductor structures 105 may be nanoribbons. Although illustrated with two first semiconductor structures 102 and two second semiconductor structures 105, any number may be deployed such as three, four, or more. The number of first semiconductor structures 102 and second semiconductor structures 105 may be the same or they may be different. As used herein, vertically aligned indicates the direction (i.e., z-detection) orthogonal to a work surface (i.e., the x-y plane) as used in the art. Similarly, a frontside 151 and a backside 152 of stacked transistor structure 100 and other structures discussed herein are defined as is common in the art with frontside 151 being the buildup side during frontend device fabrication and backside 152 being opposite frontside 151. First semiconductor structures 102 contact and extend between first conductivity type source structure 103 and first conductivity type drain structure 133 (refer to FIG. 1C). Second semiconductor structures 105 contact and extend between second conductivity type source structure 106 and second conductivity type drain structure 136.

The source and drain semiconductor materials deployed for source and drain structures 103, 133 and source and drain structures 106, 136 include any suitable material or materials for the conductivity type of the transistor structure being deployed. In some embodiments, for NMOS transistor structures, the source and drain semiconductor is epitaxial silicon doped with n-type dopants inclusive of phosphorous, arsenic, antimony, or others. In some embodiments, for PMOS transistors, the source and drain semiconductor is epitaxial silicon germanium doped with p-type dopants inclusive of boron, aluminum, gallium, indium, or others. Source and drain structures 103, 133 and source and drain structures 106, 136 may include faceting and epitaxial growth structures and characteristics, for example.

In some embodiments, first conductivity type device 141 is an NMOS transistor structure and source and drain structures 103, 133 are n-type source and drain materials (e.g., epitaxial silicon doped with n-type dopants) and second conductivity type device 142 is a PMOS transistor structure and source and drain structures 106, 136 are p-type source and drain materials (e.g., epitaxial silicon germanium doped with p-type dopants). However, in other embodiments, first conductivity type device 141 is a PMOS transistor structure and second conductivity type device 142 is an NMOS transistor structure. That is, CFET 101 may have NMOS transistor structures over PMOS transistor structures or PMOS transistor structures over NMOS transistor structures. In the following, an NMOS over PMOS architecture is described for the sake of clarity. However, it is understood the conductivity type and corresponding contact materials may be swapped.

As further shown in FIG. 1C, CFET 101 and stacked transistor structure 100 further include gate structures 123 adjacent channel regions 122 of semiconductor structures 102, 105. as used herein, a channel region indicates a region or portion of a material or structure that is manipulated by a gate to operate a transistor structure, and the transistor structure need not be in operation for a region to be a channel region. Gate structures 123 include gate dielectric 125 separating gate electrodes 124 from channel regions 122. Gate structures 123 may include any suitable materials. Gate dielectric 125 may be silicon oxide, aluminum oxide, or a high-k dielectric, such as hafnium oxide. For example, gate dielectric 125 may include elements such as hafnium, silicon, oxygen, titanium, tantalum, lanthanum, aluminum, zirconium, barium, strontium, yttrium, lead, scandium, niobium, or zinc. Gate electrodes 124 may include any suitable work function metal for gate control of channel regions 122such as tantalum, titanium, aluminum, ruthenium, or alloys of such materials. Cavity spacers 126 are between gate structures 123 and source and drain structures 103, 133, 106, 136. Cavity spacers 126 may include a low-k dielectric material such as silicon oxide, silicon nitride, silicon carbide, or the like. Furthermore, insulator layer 104 separates the components of first conductivity type device 141 and second conductivity type device 142. Insulator layer 104 may include any suitable insulator or dielectric such as silicon oxide, silicon nitride, silicon carbide, or the like.

As shown, frontside contact 107 contacts first conductivity type source structure 103 and backside contact 109 contacts second conductivity type source structure 106. Although illustrated with respect to contact to source structures 103, 106, frontside contact 107 may contact first conductivity type drain structure 133 and/or backside contact 109 may contact second conductivity type drain structure 136 in some embodiments. Furthermore, metal via 108 extends vertically (i.e., in the z-dimension) such that a portion of metal via is laterally aligned with each of frontside contact 107, first conductivity type source structure 103, second conductivity type source structure 106, and backside contact 109. Metal via 108 frontside contact 107 connects to backside metallization feature 112. For example, metal via 108 may provide power delivery for first conductivity type device 141. Similarly, backside contact 109 is in contact with backside metallization feature 114. In some embodiments, backside metallization feature 114 provides power delivery for second conductivity type device 142. Although discussed with respect to power delivery, any suitable routing such as ground or signal routing may be provided by the discussed features. As shown, backside metallization features 112, 114 may further connect to backside metallization features 113, 115, which may be part of backside metallization layers as discussed further herein. Such components may be embedded in insulator materials 110, 111, which may be any suitable insulative or dielectric materials such as silicon oxide.

Using the techniques discussed herein, frontside contact 107, backside contact 109, and metal via 108 may be advantageously selected to improve the performance of CFET 101. For example, transistor improvement may be attained for stacked transistor structure 100 (i.e., stacked devices) by metal selection of frontside contact 107, backside contact 109, and metal via 108 including, for example, dual silicide for frontside contact 107 and backside contact 109 using front and backside contact engineering. For example, the discussed techniques enable separate contact metal and silicide engineering for devices in a stacked configuration. By changing the contact metal type, depth, recess, and proximity, transistor performance may be tuned by, for example, reducing contact resistance (Rext) of the transistor. In addition or in the alternative, changing the proximity of metal via 108 to the transistor can locally induce stress on the transistors and improve its overall performance. The discussed techniques have advantages including dual metal/silicide availability since the NMOS and PMOS devices are on different planes, using different contact metals, deploying different grain sizes to impart stress for contact resistance tuning, and others.

In some embodiments, first conductivity type source structure 103 is n-type (i.e., first conductivity type device 141 is NMOS) and frontside contact 107 includes titanium and nitrogen (e.g., frontside contact 107 is or includes titanium nitride) and metal via 108 is tungsten such as substantially pure tungsten. In such embodiments, backside contact 109 may be tungsten. In some embodiments, first conductivity type source structure 103 is n-type (i.e., first conductivity type device 141 is NMOS) and frontside contact 107 includes titanium and nitrogen (e.g., frontside contact 107 is or includes titanium nitride) and metal via 108 includes a liner including titanium and nitrogen (e.g., a titanium nitride liner) and a tungsten plug within the liner. For example, the amount of tungsten and proximity to first conductivity type device 141 may tune strain in first conductivity type device 141. In some embodiments, second conductivity type device 141 is PMOS and backside contact 109 is recessed (or thinned) to increase strain on second conductivity type device 141. For example, by reducing the thickness of backside contact 109, the material of backside metallization feature 114 (e.g., copper) may advantageously impart more strain on second conductivity type device 141. Other embodiments are discussed herein below.

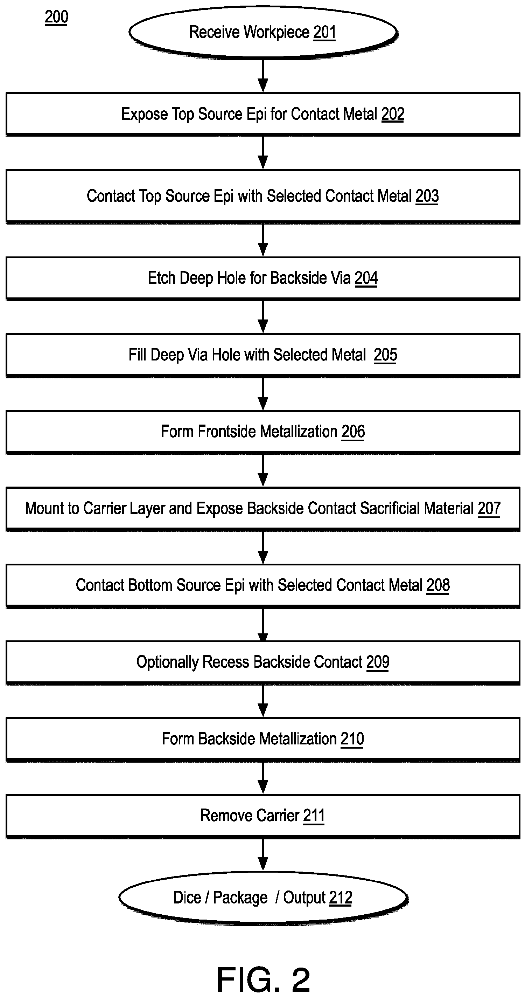

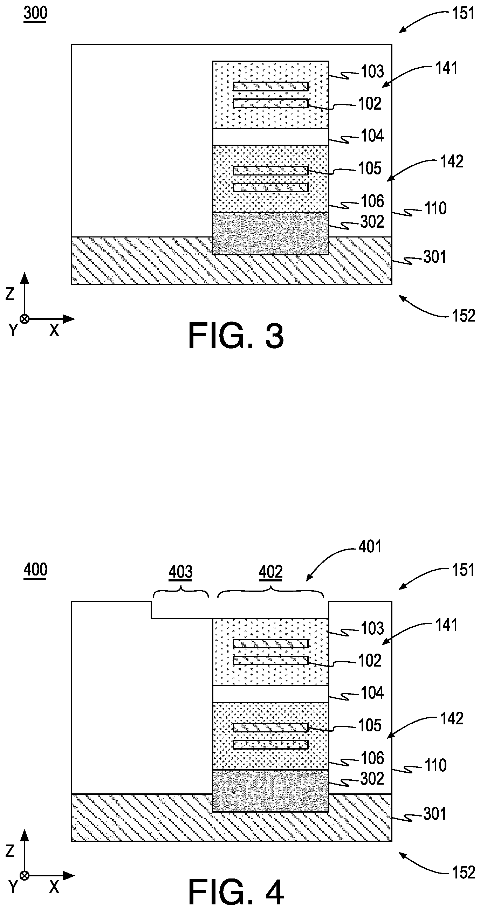

FIG. 2 is a flow diagram illustrating methods 200 for forming a stacked transistor structure having frontside contacts, backside contacts, and deep vias with selectable and tunable metals, arranged in accordance with at least some implementations of the present disclosure. FIGS. 3, 4, 5, 6, 7, 8, 9, 10, 11, 12, 13, 14, 15, 16, 17, 18A, 18B, 19, and 20 are cross-sectional side views of stacked transistor structures evolving as methods 200 are practiced, arranged in accordance with some embodiments of the disclosure. For example, FIGS. 3-20 provide the cross-sectional side view displayed in FIG. 1A illustrating operations at a source cut. Similar structures are fabricated at the drain cut as is known in the art. It is noted that operations to fabricate components evident in the gate cut of FIG. 1C may be formed prior to or after those of the source/drain cut as is known in the art.

Methods 200 begin at input operation 201, where a workpiece is received for processing. For example, a partially fabricated stacked transistor structure may be received at operation 201. In some embodiments, the partially fabricated stacked transistor structure is formed by growing nanoribbons using epitaxy (e.g., to form the material layers of semiconductor structures 102, 105), completing a fin etch (e.g., to form the semiconductor structures 102, 105) and dummy gate fabrication, depositing spacer material, and depositing a sacrificial backside contact material (e.g., which will be replaced to form backside contact 109). This processing is then followed by bottom device source and drain epitaxy (e.g., to form first conductivity type source structure 103 and first conductivity type drain structure 133), insulator deposition (e.g., to form insulator layer 104, which may be an oxide), and top device source and drain epitaxy (e.g., to form second conductivity type source structure 106 and second conductivity type drain structure 136). The dummy gate may be replaced with gate dielectric and gate electrode material (e.g., to form gate structures 123 including gate dielectric 125 and gate electrodes 124).

FIG. 3 illustrates a cross-sectional side view of a stacked transistor structure 300 including first conductivity type source and drain structures 103, 133 over second conductivity type source and drain structures 106, 136 in preparation for source and drain contact metal. As discussed, FIG. 3 provides a cross-sectional side view at a source cut as illustrated in FIG. 1A. It is noted that other components as illustrated in FIG. 1C are also fabricated as part of transistor structure 300.

As shown, stacked transistor structure 300 includes a substrate 301 over which other components of stacked transistor structure 300 are being fabricated as part of frontside 151 processing. In some embodiments, substrate 301 is a semiconductor material such as monocrystalline silicon (Si), germanium (Ge), silicon germanium (SiGe), III-V materials (e.g., gallium arsenide (GaAs)), a silicon carbide (SiC), a sapphire (Al₂O₃), or any combination thereof. For example, substrate 301 may be a substrate substantially aligned along a predetermined crystal orientation (e.g., <100>, <111>, <110>, or the like). In some embodiments, substrate 301 is silicon having a <111> crystal orientation.

First semiconductor structures 102 and first conductivity type source and drain structures 103, 133 of first conductivity type device 141 may have any characteristics discussed herein. In some embodiments, first conductivity type source and drain structures 103, 133 are n-type (i.e., first conductivity type device 141 is NMOS) and first conductivity type source and drain structures 103, 133 are epitaxial silicon (e.g., epitaxial to first semiconductor structures 102) doped with n-type dopants inclusive of phosphorous, arsenic, or antimony. Similarly, second semiconductor structures 105 and second conductivity type source and drain structures 106, 136 of second conductivity type device 142 may have any suitable characteristics. In some embodiments, second conductivity type source and drain structures 106, 136 are p-type (i.e., second conductivity type device 142 is PMOS) and second conductivity type source and drain structures 106, 136 are epitaxial silicon germanium doped with p-type dopants inclusive of boron, aluminum, gallium, or indium. In the following, discussion continues with first conductivity type device 141 being NMOS and second conductivity type device 142 being PMOS. However, it is noted the vertical orientation of NMOS and PMOS may be reversed. As shown, a sacrificial backside contact material 302 is buried under second conductivity type source structure 106 for eventual reveal and replacement. Sacrificial backside contact material 302 may be formed using any suitable technique or techniques and may include any suitable material such as titanium nitride or other material with suitable etch selectivity and other properties.

Returning to FIG. 2, processing continues at operation 202, where the top source epitaxial material is exposed using any suitable technique or techniques. In some embodiments, the source structure is exposed using lithography and etch techniques. Notably, exposing the top source epitaxial material may form a location for a source contact and an extension for coupling to a deep via, as discussed further below. Although illustrated with respect to contacting a source structure, a drain structure may be contacted in addition or in the alternative.

FIG. 4 illustrates a cross-sectional side view of a stacked transistor structure 400 similar to stacked transistor structure 300 after formation of opening 401. As discussed, opening 401 may be formed using any suitable technique or techniques including lithography and etch techniques. Opening 401 is formed in insulator material 110 to expose first conductivity type source structure 103 (e.g., an n-type source structure) and to provide an extension in which a source contact may couple to a deep via. For example, opening 401 may include a region 402 over first conductivity type source structure 103 and a region 403 that is contiguous with region 402 and that is laterally adjacent (i.e., not over any portion of) first conductivity type source structure 103, insulator layer 104, and second conductivity type source structure 106, or any other device component. Thereby, region 402 extends to a position at which a deep via may be formed through insulator material 110.

Returning to FIG. 2, processing continues at operation 203, where the top source epitaxial material is contacted with a source contact. The source contact metal may be formed using any suitable technique or techniques such as deposition methods inclusive of atomic layer deposition (ALD) followed by planarization operations. In some embodiments, the source or drain contact is or includes titanium nitride (e.g., includes titanium and nitrogen) and the source or drain has n-type conductivity. Advantageously, titanium nitride has low contact resistance to n-type conductivity source/drain epi. As discussed with respect to the opening formed at operation 202. The source contact may extend over isolation material to provide a location to form a metal via that may contact the source contact.

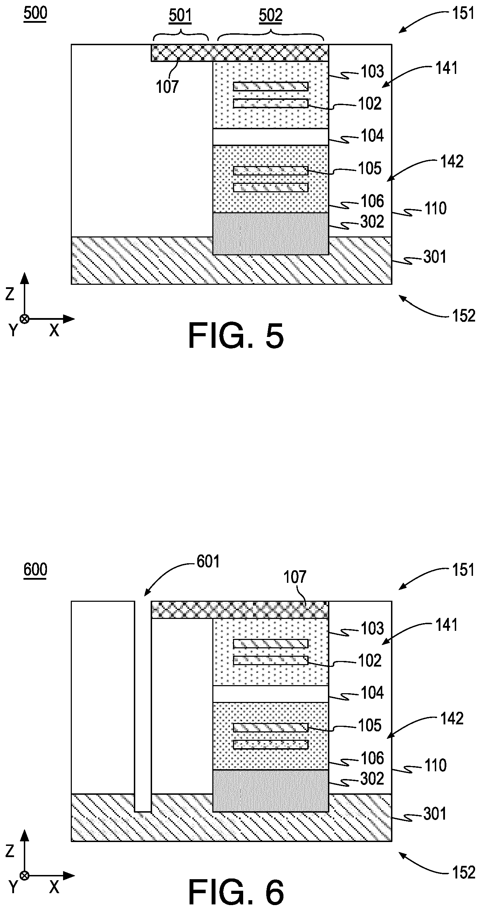

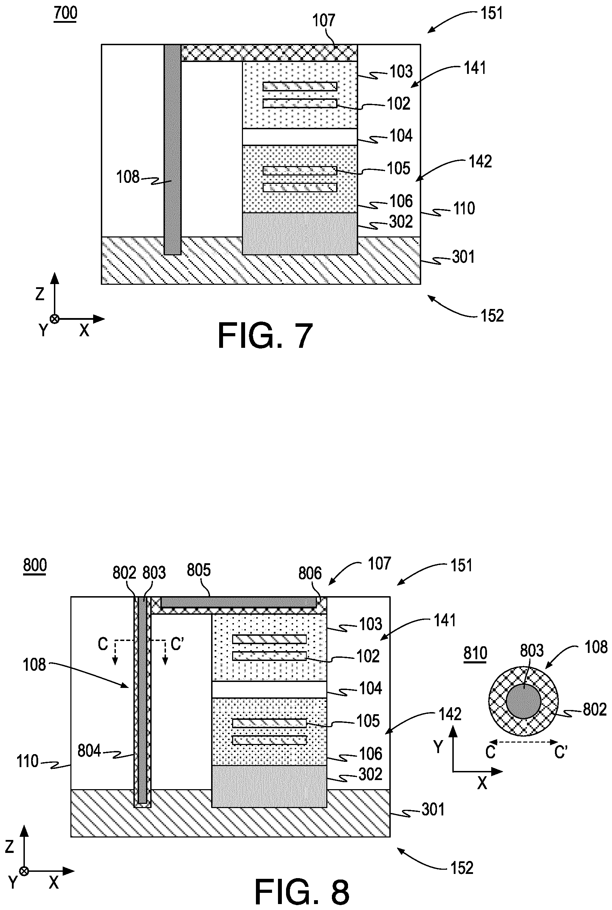

FIG. 5 illustrates a cross-sectional side view of a stacked transistor structure 500 similar to stacked transistor structure 400 after formation of frontside contact 107, which may be a titanium nitride contact on an n-type source structure. In some embodiments, frontside contact 107 includes a titanium nitride portion and additional fill metal such as tungsten, as illustrated with respect to FIG. 8 herein below. As discussed, frontside contact 107 may be formed via ALD and subsequent planarization. Frontside contact 107 includes a portion 502 on and over first conductivity type source structure 103 (e.g., an n-type source) and a portion 501 that extends laterally adjacent first conductivity type source structure 103, insulator layer 104, and second conductivity type source structure 106, or any other device component. Thereby, portion 501 extends to a position at which a deep via may be formed through insulator material 110.

Returning to FIG. 2, processing continues at operation 204, where a deep hole is etched to bypass the stacked transistor device, extend below the stacked transistor device (and optionally into the underlying substrate) to form a via hole that can be filled and ultimately accessed from a backside of the device. Furthermore, the deep hole may extend through or abut the previously formed frontside contact such that the frontside contact will ultimately be conductively coupled to backside metallization.

FIG. 6 illustrates a cross-sectional side view of a stacked transistor structure 600 similar to stacked transistor structure 500 after formation of opening 601, which may be formed using any suitable technique or techniques including lithography and etch techniques. Opening 601 is formed in insulator material 110 (and optionally a portion of frontside contact 107) such that opening 601 adjoins frontside contact 107 and extends vertically at or below the stack of first conductivity type source structure 103, insulator layer 104, and second conductivity type source structure 106 such that opening 601 is laterally adjacent each of source structure 103, insulator layer 104, and second conductivity type source structure 106.

Returning to FIG. 2, processing continues at operation 205, where the deep hole or opening formed at operation 204 is filled a selected via metal or metals. As discussed, the via metal may be different with respect to the metal used to contact the source or drain structure. In some embodiments, the metal via is substantially pure tungsten. In some embodiments, the metal via is pure tungsten. In some embodiments, the metal fill may include a liner layer or an adhesion layer. The metal fill may be formed using any suitable technique or techniques such as metal deposition followed by planarization. In some embodiments, the metal via includes a liner of titanium nitride and a tungsten plug. In some embodiments, the proportion of titanium nitride liner to tungsten plug material may be tuned to provide strain tuning to improve device performance.

FIG. 7 illustrates a cross-sectional side view of a stacked transistor structure 700 similar to stacked transistor structure 600 after formation of metal via 108. As discussed, in some embodiments, frontside contact 107 is or includes titanium nitride and metal via 108 is or includes tungsten. For example, frontside contact 107 may include titanium and nitrogen and metal via may include tungsten or may be substantially pure or pure tungsten.

FIG. 8 illustrates a cross-sectional side view of a stacked transistor structure 800 similar to stacked transistor structure 600 after formation of metal via 108 including a titanium nitride liner 802 and a tungsten fill 803. Titanium nitride liner 802 and a tungsten fill 803 may be formed using any suitable technique or techniques such as deposition of a conformal titanium nitride liner on sidewall 804, tungsten fill deposition on the conformal titanium nitride liner, followed by a planarization operation or operations to form metal via 108. Insert 810 of FIG. 8 illustrates metal via 108 may have a substantially circular cross section (i.e., in the x-y plane) in some embodiments. However, metal via 108 may have any suitable cross-sectional shape.

FIG. 8 further illustrates frontside contact 107 may include a titanium nitride liner 806 and a tungsten fill 805. Titanium nitride liner 806 and a tungsten fill 805 may be formed at operation 203. In some embodiments, a portion of titanium nitride liner 802 abuts a portion of titanium nitride liner 806, as shown. In some embodiments, a portion of titanium nitride liner 802 abuts tungsten fill 805. Notably, a tungsten only (or high proportion of tungsten) filled metal via 108, may provide undesirable strain to a PMOS device, whether deployed as first conductivity type device 141 or second conductivity type device 142. By reducing the amount of tungsten in metal via 108 using titanium nitride liner 802, the amount of undesirable strain may be reduced or eliminated. In some embodiments, metal via 108 it not less than 20% titanium nitride by volume. In some embodiments, metal via 108 it not less than 40% titanium nitride by volume. In some embodiments, metal via 108 it not less than 50% titanium nitride by volume. In some embodiments, metal via 108 includes a greater proportion of titanium nitride than frontside contact 107. For example, in some embodiments metal via 108 includes a greater proportion of titanium than frontside contact 107. Although illustrated with respect to frontside contact 107 including titanium nitride liner 806 and tungsten fill 805, metal via 108 including titanium nitride liner 802 and tungsten fill 803 may be fabricated adjacent frontside contact 107 including only titanium nitride.

In the following, stacked transistor structure 700 illustrated in the subsequent processing operations. However, stacked transistor structure 800 may be implemented without restriction.

Returning to FIG. 2, processing continues at operation 206, where one or more frontside metallization layers are fabricated over the device structure. Prior to frontside metallization layer fabrication, any remaining transistor device processing may be completed. Such processing may include, for example, replacement of dummy gate materials with gate structures (if not previously replaced), contacting the gate structures and/or other source and drain structures, dielectric fill operations, and the like. Frontside metallization layers may then be formed over (and selectively coupled to) the frontside contacts using any suitable technique or techniques such as dual damascene techniques, single damascene techniques, subtractive metallization patterning techniques, or the like.

Processing continues at operation 207, where the partially fabricated workpiece is mounted, by its frontside, to a carrier such as a carrier wafer, and the backside contact sacrificial material is exposed through the backside of the substrate of the workpiece. The workpiece may be mounted to the carrier using any suitable technique or techniques such as application of an adhesive film between the workpiece and the carrier. The backside contact sacrificial material is exposed using any suitable technique or techniques such as backside substrate removal processing including backside grind, backside etch, or the like to thin the substrate wafer and/or remove the entirety of the substrate wafer.

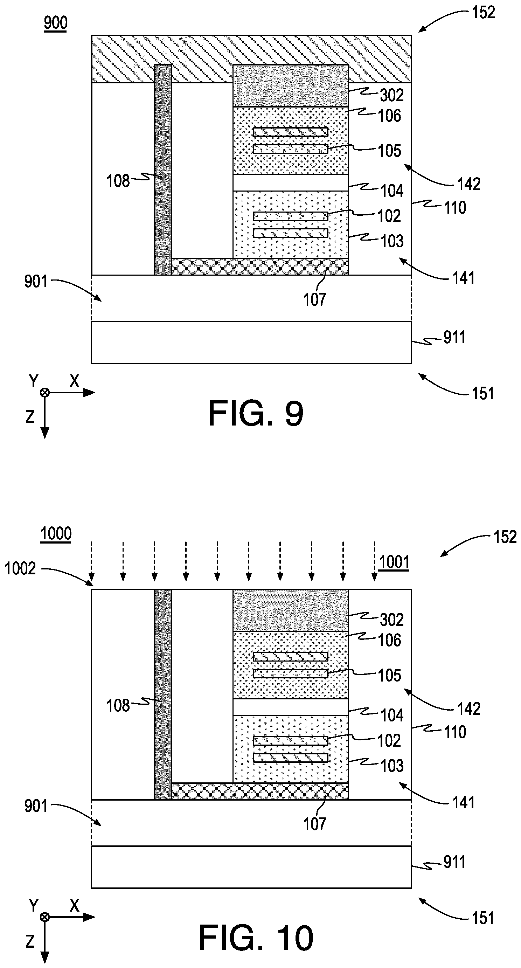

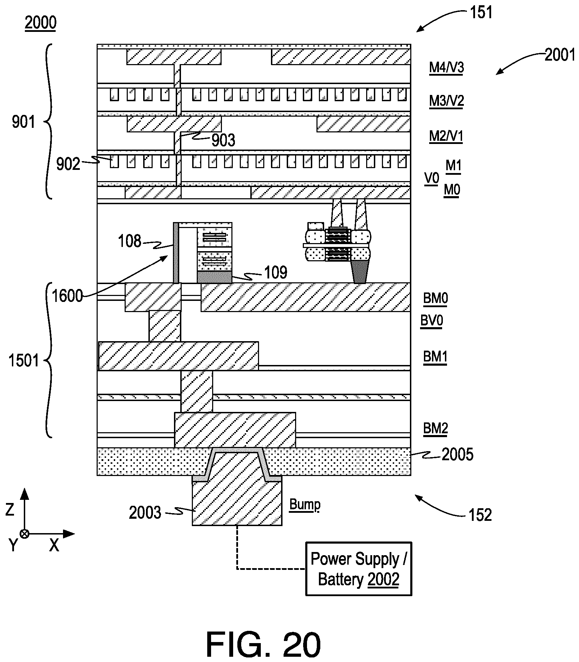

FIG. 9 illustrates a cross-sectional side view of a stacked transistor structure 900 similar to stacked transistor structure 700 after formation of frontside metallization layers 901 (or frontside interconnect layers) and after attachment to carrier 911. In the context of FIG. 9, details of frontside metallization layers 901 are not shown for sake of clarity of presentation. Exemplary details of frontside metallization layers 901 are illustrated herein below with respect to FIG. 20. Furthermore, the view of FIG. 9 is inverted with respect to that of FIG. 8 due to attachment to carrier 911.

Frontside metallization layers 901 may be formed using any suitable technique or techniques such as dual damascene techniques, single damascene techniques, subtractive metallization patterning techniques, or the like. For example, interconnectivity, signal routing, power-delivery, and the like may be provided by frontside metallization layers 901. As used herein, the term metallization layer indicates metal interconnections or wires that provide electrical routing. Adjacent metallization layers, such as metallization interconnects 902, are interconnected by via. The metallization layer may include such vias or the vias may interconnect metallization layer.

FIG. 9 further illustrates attachment to carrier 911, which may be any suitable support substrate such as a wafer. For example, carrier 911 may be a silicon wafer or a silicon-on-insulator wafer or the like. Frontside metallization layers 901 (or a layer over frontside metallization layers 901) may be mounted to carrier 911 using, for example, an adhesive film, bonding layers, or the like (not shown) therebetween.

FIG. 10 illustrates a cross-sectional side view of a stacked transistor structure 1000 similar to stacked transistor structure 900 after backside substrate removal processing 1001 to expose a backside surface 1002. For example, substrate removal processing 1001 may include backside grind (e.g., backside planarization) and/or backside etch processing that thins substrate 301 in a planar fashion to expose instances of sacrificial backside contact material 302 for backside contact processing. For example, sacrificial backside contact material 302 may be exposed by removal of a portion of substrate 301. In the context of FIG. 10, the entirety of substrate 301 is removed. However, a thin layer or portions of substrate 301 may remain after substrate removal processing 1001.

Returning to FIG. 2, processing continues at operation 208, where the exposed sacrificial backside contact material is removed and replaced with a selected metal material that contacts the bottom source epi. In some embodiments, the backside contact sacrificial material is removed using selective etch processing and replaced with selected backside contact metal using deposition and planarization techniques.

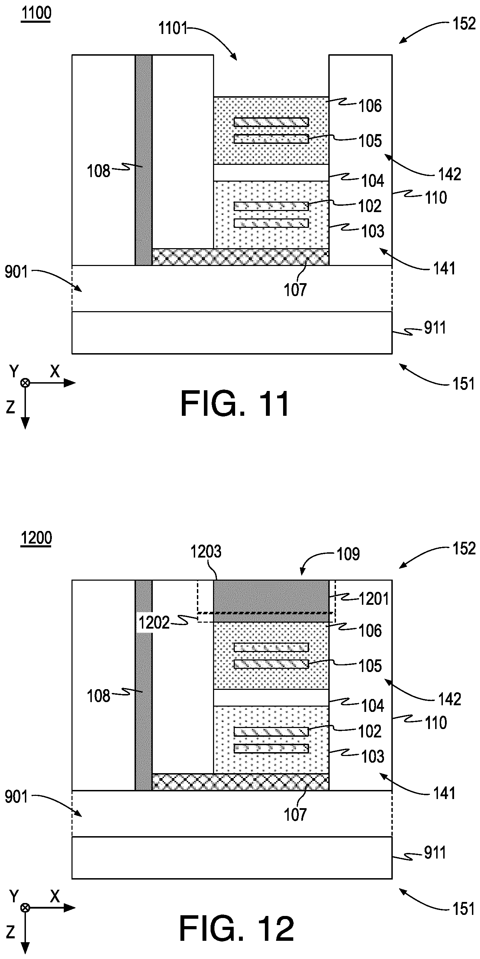

FIG. 11 illustrates a cross-sectional side view of a stacked transistor structure 1100 similar to stacked transistor structure 1000 after selective removal of sacrificial backside contact material 302 to form opening 1101. For example, sacrificial backside contact material 302 may be removed using selective wet etch or dry etch techniques based on the etch selectivity between sacrificial backside contact material 302 (e.g., titanium nitride) and insulator material 110 (e.g., silicon oxide).

FIG. 12 illustrates a cross-sectional side view of a stacked transistor structure 1200 similar to stacked transistor structure 1100 after formation of backside contact 109 by, for example, metal deposition followed by planarization. As discussed, the present techniques allow for the selection of the metals of frontside contact 107, metal via 108, and backside contact 109. In the context of second conductivity type source structure 106 being p-type (i.e., second conductivity type device 142 is a PMOS transistor structure), backside contact 109 may include tungsten 1201. In some embodiments, backside contact 109 includes a tungsten silicide portion 1202 (i.e., including tungsten and silicon) that transitions to a pure or substantially pure tungsten region 1203.

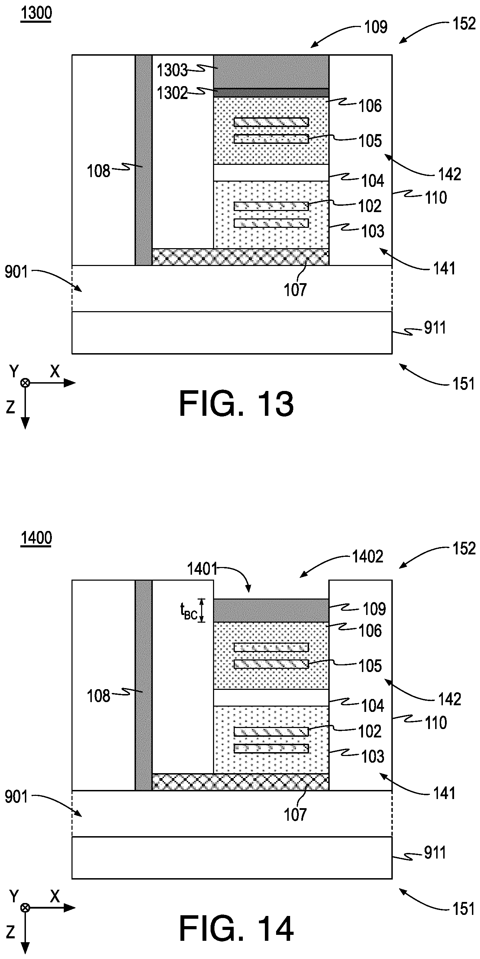

FIG. 13 illustrates a cross-sectional side view of a stacked transistor structure 1300 similar to stacked transistor structure 1100 after formation of backside contact 109 such that backside contact 109 includes a nickel-platinum material 1302 and a fill metal 1303. For example, in the context of second conductivity type source structure 106 being p-type (i.e., second conductivity type device 142 is a PMOS transistor structure) backside contact 109 may include a nickel-platinum material 1302 and a fill metal 1303. In some embodiments, nickel-platinum material 1302 is a nickel-platinum silicide, NiPtSi (i.e., a material including nickel, platinum, and silicon). In some embodiments, fill metal 1303 is or includes tungsten. In some embodiments, fill metal 1303 is substantially pure or pure tungsten. Nickel-platinum material 1302 and a fill metal 1303 may be formed using any suitable technique or techniques such as nickel and platinum sputter followed by rapid thermal anneal to form nickel-platinum material 1302, followed by deposition of fill metal 1303 and planarization.

Returning to FIG. 2, processing continues at operation 209, where the backside contact formed at operation 208 may be recessed. The backside contact may be recessed using any suitable technique or techniques such as recess etch techniques. Notably, such recessing provides strain tuning for the adjacent transistor structure. In the context of GAA transistor structures, applying strain is difficult due to the source and drain structures being epitaxially grown from the semiconductor structures (and not in a bottom-up fashion, which provides more strain). Instead, the epi source and drain structures nucleate from the semiconductor structure ribbons and loses its ability to apply strain. By recessing the backside contact, the subsequently formed copper metallization features are able to impart strain on the adjacent device (which is advantageous for PMOS devices). The applied strain increases mobility and offers other advantages. The backside contact may be recessed to any suitable thickness such as thickness of not more than 15 nm, a thickness of not more than 10 nm, or a thickness of not mor than 5 nm. Other thicknesses may be used.

FIG. 14 illustrates a cross-sectional side view of a stacked transistor structure 1400 similar to stacked transistor structure 1200 after recess of backside contact 109 to form a recessed backside contact 1401 having a reduced backside contact thickness t_{BC}, and an opening 1402 Although illustrated with respect to reducing the thickness of backside contact 109 in the context of a tungsten-based contact (discussed with respect to FIG. 12), any backside contact may be reduced in size such as the nickel-platinum silicide and tungsten contact discussed with respect to FIG. 13. In either context, the bulk tungsten thickness may be reduced without recessing the silicide or the silicide may also be recessed.

Backside contact 109 may be recessed using selective etch techniques and the resultant thickness tsc may be tuned to provide the proper strain to second conductivity type device 142 (e.g., a PMOS device). For example, recessing backside contact 109 will allow a subsequent metallization to provide a predictable amount of strain to second conductivity type device 142. Thickness tsc may be any suitable dimension to realize the desired strain on second conductivity type device 142. In some embodiments, thickness t_{BC} is in the range of 2 to 15 nm. In some embodiments, thickness t_{BC} is in the range of 5 to 10 nm. In some embodiments, thickness t_{BC} is in the range of 10 to 15 nm. In some embodiments, thickness t_{BC} is not more than 15 nm. In some embodiments, thickness t_{BC} is not more than 10 nm. In some embodiments, thickness t_{BC} is not more than 5 nm. Other thicknesses may be used depending on the desired strain and other characteristics such as contact resistance.

Returning to FIG. 2, processing continues at operation 210, backside metallization layers are formed over the backside contacts discussed with respect to operation 209. Such backside metallization layers may be formed over (and selectively coupled to) the backside contacts using any suitable technique or techniques such as dual damascene techniques, single damascene techniques, subtractive metallization patterning techniques, or the like.

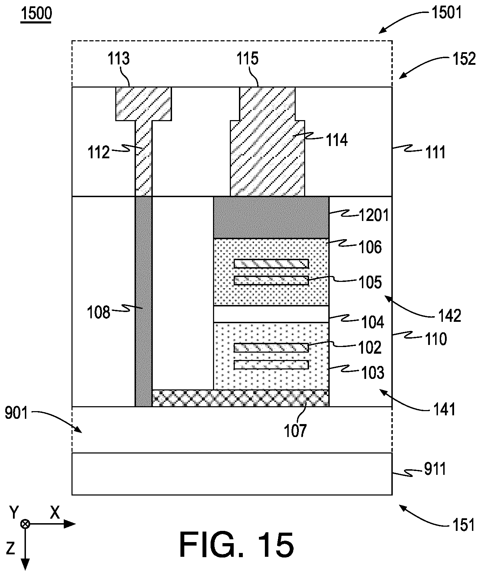

FIG. 15 illustrates a cross-sectional side view of a stacked transistor structure 1500 similar to stacked transistor structure 1200 after formation of metallization features 112, 113, 114, 115 and optional additional backside metallization layers 1501 (or backside interconnect layers). In the context of FIG. 15, details of backside metallization layers 1501 are not shown for sake of clarity of presentation. Exemplary details of backside metallization layers 1501 are illustrated herein below with respect to FIG. 20. Furthermore, stacked transistor structure 1500 includes the features of stacked transistor structure 1200. However, any suitable stacked transistor structure may be deployed in the continued processing discussed herein.

Metallization features 112, 113, 114, 115 and additional backside metallization layers 1501 may be formed using any suitable technique or techniques such as dual damascene techniques, single damascene techniques, subtractive metallization patterning techniques, or the like. For example, interconnectivity and power-delivery may be provided by backside metallization layers 1501. Notably, metal via 108 contacts metallization feature 112 (which contacts metallization feature 113) such that power delivery or other electrical access is provided to first conductivity type source structure 103 from backside 152. Such backside power delivery removes the requirement of frontside power delivery to first conductivity type source structure 103, which advantageously allows for greater device density in the x-y plane.

Processing continues at operation 211, where the carrier is removed using any suitable technique or techniques such as delamination, UV curing, or the like, and at operation 212, where continued processing is performed as is known in the art. Such processing may include dicing, packaging, assembly, and so on. The resultant device (e.g., integrated circuit die) may then be implemented in any suitable form factor device such as a laptop, a netbook, a notebook, an ultrabook, a smartphone, a tablet, a personal digital assistant, an ultra-mobile PC, a mobile phone, a desktop computer, a server, a printer, a scanner, a monitor, a set-top box, an entertainment control unit, a digital camera, a portable music player, a digital video recorder, or the like.

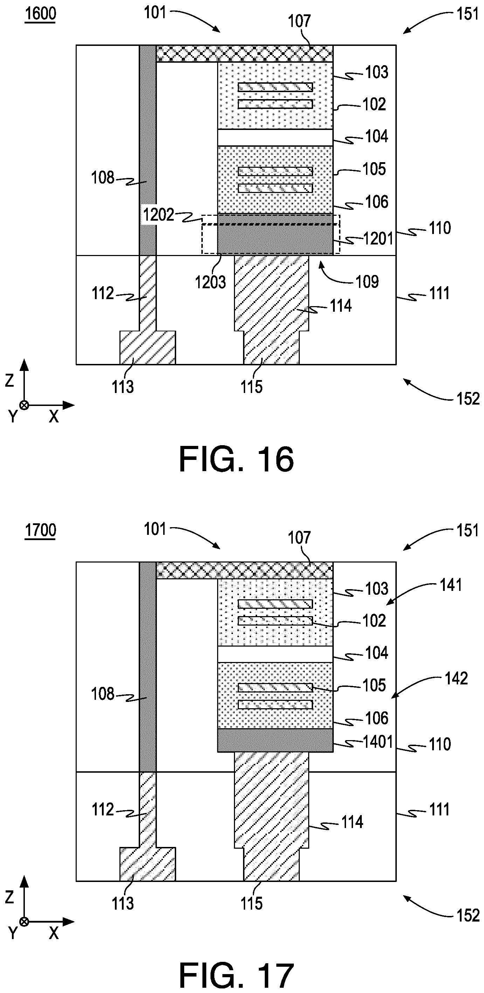

FIGS. 16, 17, 18A, 18B, and 19 illustrate cross-sectional side views of stacked transistor structures 1600, 1700, 1800, 1900 similar to stacked transistor structure 1500 after removal of carrier 911 and with particular combinations of frontside contact 107, backside contact 109, and metal via 108 in accordance with some embodiments. In the views of FIGS. 16 to 19, frontside metallization layers 901 and backside metallization layers 1501 are not shown for the sake of clarity of presentation. Furthermore, the views of FIGS. 16 to 19 are inverted back to having frontside 151 being at the top of the page. Notably, the particular features of each of frontside contact 107, backside contact 109, and metal via 108 discussed with respect to NMOS device 141 and PMOS device 142 may be deployed in any permutation in a stacked transistor structure.

As shown in FIGS. 16 to 19, in some embodiments, CFET 101 includes vertically first semiconductor structures 102 and second semiconductor structures 105, first conductivity type source structure 103 coupled to first semiconductor structures 102, and second conductivity type source structure 106 coupled to second semiconductor structures 105. Frontside contact 107 is on first conductivity type source structure 103 and backside contact 109 is on second conductivity type source structure 106 such that frontside contact 107 is opposite first conductivity type source structure 103 and second conductivity type source structure 106 from backside contact 109. That is, first conductivity type source structure 103 and second conductivity type source structure 106 are between frontside contact 107 and backside contact 109. Metal via 108 extends adjacent to frontside contact 107, first conductivity type source structure 103, second conductivity type source structure 106, and backside contact 109.

As shown in FIG. 16, stacked transistor structure 1600 deploys a titanium nitride frontside contact 107 on an n-type source structure 103 (as shown) and/or an n-type drain structure 133, backside contact 109 including tungsten on a p-type source structure 106 (as shown) and/or a p-type drain structure 136, and metal via 108 including tungsten. For example, backside contact 109 of stacked transistor structure 1600 may include tungsten 1201 such that backside contact 109 includes tungsten silicide portion 1202 (i.e., including tungsten and silicon) that transitions to a pure or substantially pure tungsten region 1203. In some embodiments, metal via 108 is substantially pure or pure tungsten. The embodiment of stacked transistor structure 1600 improves NMOS contact resistance by deploying titanium nitride frontside contact 107 on an n-type source structure 103 (as shown) and/or an n-type drain structure 133.

In FIG. 17, stacked transistor structure 1700 has a titanium nitride frontside contact 107 on an n-type source structure 103 (as shown) or an n-type drain structure 133, backside contact 109 having a tungsten recessed backside contact 1401 on a p-type source structure 106 (as shown) or a p-type drain structure 136, and metal via 108 including tungsten. Recessed backside contact 1401 may include tungsten or any other material discussed herein. In some embodiments, recessed backside contact 1401 includes a tungsten silicide portion (i.e., including tungsten and silicon) that transitions to a pure or substantially pure tungsten region as discussed with respect to stacked transistor structure 1600. In some embodiments, metal via 108 is substantially pure or pure tungsten. By recessing backside contact 1401, backside metallization feature 114 may advantageously strain PMOS device 142.

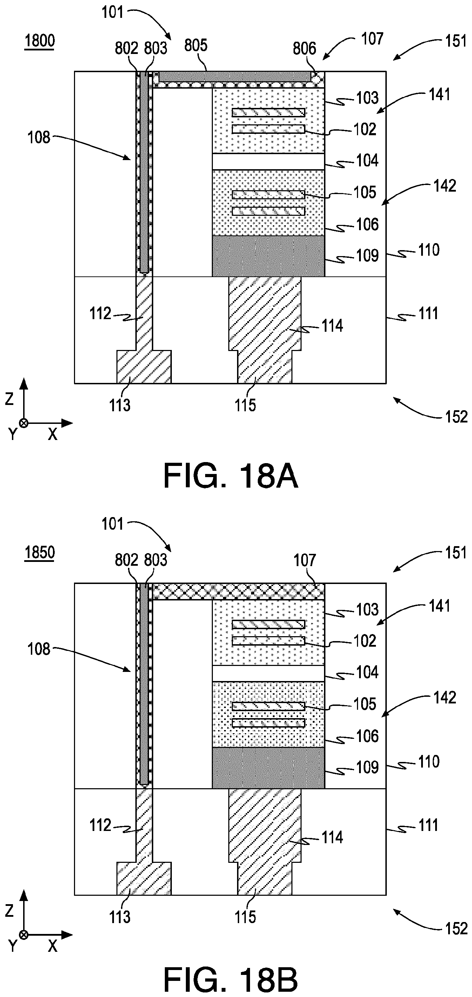

Turning now to FIG. 18A, stacked transistor structure 1800 includes frontside contact 107 on an n-type source structure 103 (as shown) or an n-type drain structure 133 such that frontside contact 107 includes titanium nitride liner 806 and tungsten fill 805, backside contact 109 including tungsten on a p-type source structure 106 (as shown) or a p-type drain structure 136, and metal via 108 including titanium nitride liner 802 and tungsten fill 803. In some embodiments, backside contact 109 of stacked transistor structure 1800 includes tungsten such that backside contact 109 includes a tungsten silicide portion (i.e., including tungsten and silicon) that transitions to a pure or substantially pure tungsten region as discussed with respect to stacked transistor structure 1600. The embodiment of stacked transistor structure 1800 improves NMOS contact resistance by deploying titanium nitride liner 806 and may improve conductivity in some contexts by using tungsten fill 805. Furthermore, the use of tungsten fill 803 may be used to tune the strain on NMOS device 141. In some embodiments, metal via 108 is not further than 10 nm laterally (i.e., in the x-dimension) from first conductivity type source structure 103 and second conductivity type source structure 106 to impart stain on NMOS device 141. In some embodiments, metal via 108 is not further than 5 nm laterally from first conductivity type source structure 103 and second conductivity type source structure 106.

In FIG. 18B, stacked transistor structure 1850 deploys frontside contact 107 on an n-type source structure 103 (as shown) or an n-type drain structure 133 such that frontside contact 107 includes titanium nitride, backside contact 109 including tungsten on a p-type source structure 106 (as shown) or a p-type drain structure 136, and metal via 108 including titanium nitride liner 802 and tungsten fill 803. In some embodiments, backside contact 109 of stacked transistor structure 1800 includes tungsten such that backside contact 109 includes a tungsten silicide portion (i.e., including tungsten and silicon) that transitions to a pure or substantially pure tungsten region as discussed with respect to stacked transistor structure 1600. The embodiment of stacked transistor structure 1850 offers improved NMOS offers contact resistance and NMOS device 141 strain tuning.

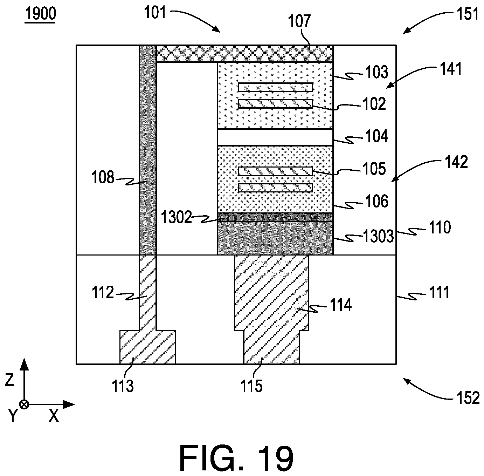

Finally FIG. 19 illustrates stacked transistor structure 1900 deploying a titanium nitride frontside contact 107 on an n-type source structure 103 (as shown) or an n-type drain structure 133, backside contact 109 including nickel-platinum material 1302 on a p-type source structure 106 (as shown) or a p-type drain structure 136 and fill metal 1303 on nickel-platinum material 1302, and metal via 108 including tungsten. For example, nickel-platinum material 1302 may be nickel platinum silicide and metal via 108 may be substantially pure or pure tungsten. Backside contact 109 of stacked transistor structure 1900

FIG. 20 illustrates a cross-sectional side view of a stacked transistor structure 2000 similar to stacked transistor structure 1600 illustrating frontside metallization layers 901 (or front interconnect layers) and backside metallization layers 1501 (or backside interconnect layers). As discussed, frontside metallization layers 901 and Backside metallization layers 1501 may be formed using any suitable technique or techniques such as dual damascene techniques, single damascene techniques, subtractive metallization patterning techniques, or the like.

For example, interconnectivity, signal routing, power-delivery, and the like may be provided by frontside metallization layers 901. Adjacent metallization layers, such as metallization interconnects 902, are interconnected by vias, such as vias 903, that may be characterized as part of the metallization layers or between the metallization layers. As shown, in some embodiments, frontside metallization layers 901 are formed over and immediately adjacent stacked transistor structure 1600. In the illustrated example, frontside metallization layers 901 include M0, V0, M1, M2/V1, M3/V2, and M4/V3. However, frontside metallization layers 901 may include any number of metallization layers such as six, eight, or more metallization layers.

Similarly, backside metallization layers 1501, which may include backside metallization features 112, 114 as part of backside metallization level 0 (BM0) and backside metallization features 113, 115 as part of a backside via level 0 (BV0), may be used for power delivery and any other suitable electrical connectivity. In the illustrated example, package level interconnects 2003 are provided on or over backside 152 as bumps over a passivation layer 2005. However, package level interconnects 2003 may be provided using any suitable interconnect structures such as bond pads, solder bumps, etc. As shown, in some embodiments, backside metallization layers 1501 are formed over and immediately adjacent stacked transistor structure 1600. In the illustrated example, backside metallization layers 1501include BM0, BM1, and BM2 with intervening via layers. However, backside metallization layers 1501 may include any number of metallization layers such as three, four, or more metallization layers.

Although illustrated with respect to stacked transistor structure 1600, any stacked transistor structure discussed herein, including any suitable characteristics, may be deployed in stacked transistor structure 2000, including stacked transistor structure 1700, stacked transistor structure 1800, or stacked transistor structure 1900. In some embodiments, transistor structure 2000 is deployed in a monolithic integrated circuit (IC) die 2001 including a stacked transistor structure (e.g., a CFET), the stacked transistor structure including any of the discussed components and characteristics. As shown, a power supply 2002 may be coupled to IC die 2001, such that power supply 2002 may include a battery, voltage converter, power supply circuitry, or the like.

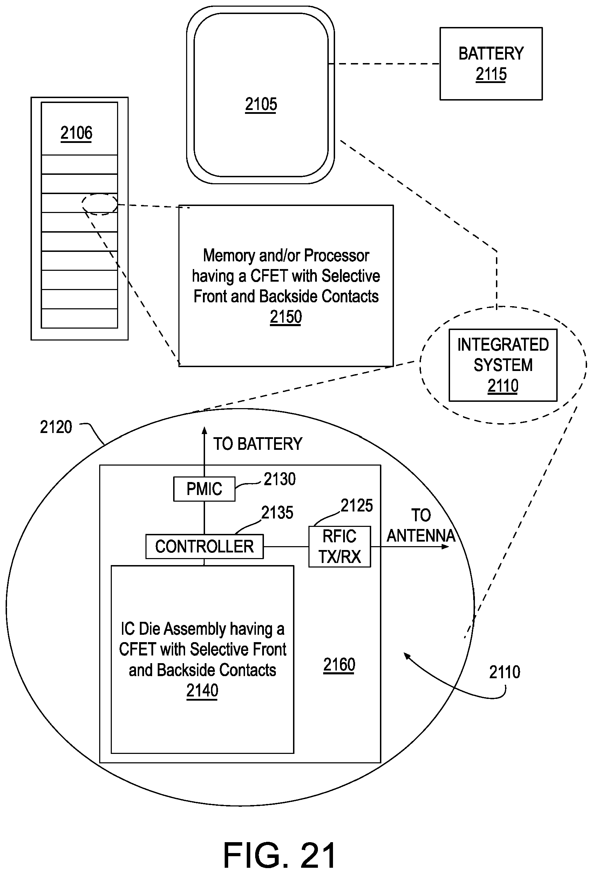

FIG. 21 illustrates exemplary systems employing stacked transistor structures having frontside contacts, backside contacts, and deep vias with selectable and tunable metals, in accordance with some embodiments. The system may be a mobile computing platform 2105 and/or a data server machine 2106, for example. Either may employ a monolithic IC die, for example, with stacked transistor structures having frontside contacts, backside contacts, and deep vias with selectable and tunable metals as described elsewhere herein. Server machine 2106 may be any commercial server, for example including any number of high-performance computing platforms disposed within a rack and networked together for electronic data processing, which in the exemplary embodiment includes an IC die assembly 2150 with a complementary field effect transistor including stacked transistor structures having frontside contacts, backside contacts, and deep vias with selectable and tunable metals as described elsewhere herein. Mobile computing platform 2105 may be any portable device configured for each of electronic data display, electronic data processing, wireless electronic data transmission, or the like. For example, mobile computing platform 2105 may be any of a tablet, a smart phone, a laptop computer, etc., and may include a display screen (e.g., a capacitive, inductive, resistive, or optical touchscreen), a chip-level or package-level integrated system 2110, and a battery/power supply 2115. Although illustrated with respect to mobile computing platform 2105, in other examples, chip-level or package-level integrated system 2110 and a battery/power supply 2115 may be implemented in a desktop computing platform, an automotive computing platform, an internet of things platform, or the like. As discussed below, in some examples, the disclosed systems may include a sub-system 2160 such as a system on a chip (SOC) or an integrated system of multiple ICs, which is illustrated with respect to mobile computing platform 2105.

Whether disposed within integrated system 2110 illustrated in expanded view 2120 or as a stand-alone packaged device within data server machine 2106, sub-system 2160 may include memory circuitry and/or processor circuitry 2140 (e.g., RAM, a microprocessor, a multi-core microprocessor, graphics processor, etc.), a power management integrated circuit (PMIC) 2130, a controller 2135, and a radio frequency integrated circuit (RFIC) 2125 (e.g., including a wideband RF transmitter and/or receiver (TX/RX)). As shown, one or more IC dice, such as memory circuitry and/or processor circuitry 2140 may be assembled and implemented such that one or more have stacked transistor structures having frontside contacts, backside contacts, and deep vias with selectable and tunable metals as described herein. In some embodiments, RFIC 2125 includes a digital baseband and an analog front end module further comprising a power amplifier on a transmit path and a low noise amplifier on a receive path). Functionally, PMIC 2130 may perform battery power regulation, DC-to-DC conversion, etc., and so has an input coupled to battery/power supply 2115, and an output providing a current supply to other functional modules. As further illustrated in FIG. 21, in the exemplary embodiment, RFIC 2125 has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. Memory circuitry and/or processor circuitry 2140 may provide memory functionality for sub-system 2160, high level control, data processing and the like for sub-system 2160. In alternative implementations, each of the SOC modules may be integrated onto separate ICs coupled to a package substrate, interposer, or board.

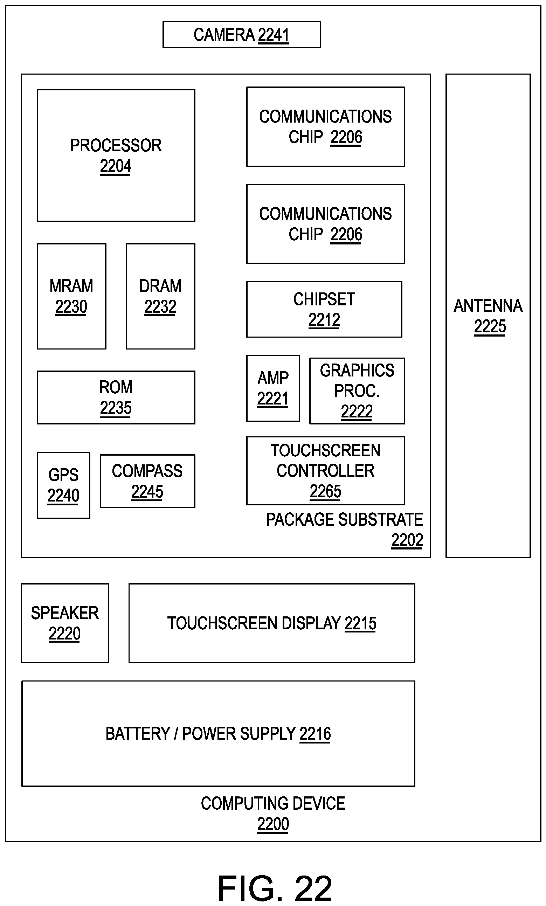

FIG. 22 is a functional block diagram of an electronic computing device 2200, in accordance with some embodiments. For example, device 2200 may, via any suitable component therein, implement a field effect transistor stacked transistor structures having frontside contacts, backside contacts, and deep vias with selectable and tunable metals as discussed herein. For example, one or more IC dies of electronic computing device 2200 may deploy stacked transistor structures having frontside contacts, backside contacts, and deep vias with selectable and tunable metals. Device 2200 further includes a motherboard or package substrate 2202 hosting a number of components, such as, but not limited to, a processor 2204 (e.g., an applications processor). Processor 2204 may be physically and/or electrically coupled to package substrate 2202. In some examples, processor 2204 is within an IC assembly. In general, the term "processor" or "microprocessor" may refer to any device or portion of a device that processes electronic data from registers and/or memory to transform that electronic data into other electronic data that may be further stored in registers and/or memory.

In various examples, one or more communication chips 2206 may also be physically and/or electrically coupled to the package substrate 2202. In further implementations, communication chips 2206 may be part of processor 2204. Depending on its applications, computing device 2200 may include other components that may or may not be physically and electrically coupled to package substrate 2202. These other components include, but are not limited to, volatile memory (e.g., DRAM 2232), non-volatile memory (e.g., ROM 2235), flash memory (e.g., NAND or NOR), magnetic memory (MRAM 2230), a graphics processor 2222, a digital signal processor, a crypto processor, a chipset 2212, an antenna 2225, touchscreen display 2215, touchscreen controller 2265, battery/power supply 2216, audio codec, video codec, power amplifier 2221, global positioning system (GPS) device 2240, compass 2245, accelerometer, gyroscope, speaker 2220, camera 2241, and mass storage device (such as hard disk drive, solidstate drive (SSD), compact disk (CD), digital versatile disk (DVD), and so forth, or the like.

Communication chips 2206 may enable wireless communications for the transfer of data to and from the computing device 2200. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not. Communication chips 2206 may implement any of a number of wireless standards or protocols, including, but not limited to, those described elsewhere herein. As discussed, computing device 2200 may include a plurality of communication chips 2206. For example, a first communication chip may be dedicated to shorter-range wireless communications, such as Wi-Fi and Bluetooth, and a second communication chip may be dedicated to longer-range wireless communications such as GPS, EDGE, GPRS, CDMA, WiMAX, LTE, Ev-DO, and others. Battery/power supply 2216 may include any suitable power supply circuitry and, optionally, a battery source to provide power to components of electronic computing device 2200.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that the invention is not limited to the embodiments so described but can be practiced with modification and alteration without departing from the scope of the appended claims. For example, the above embodiments may include specific combinations of features as further provided below.

The following pertains to exemplary embodiments.

In one or more first embodiments, an apparatus comprises a complementary field effect transistor comprising one or more first semiconductor structures vertically aligned with one or more second semiconductor structures, an n-type source structure coupled to the first semiconductor structures, and a p-type source structure coupled to the second semiconductor structures, a first contact on the n-type source structure and a second contact on the p-type source structure, wherein the first contact is opposite the n-type source structure and the p-type source structure from the second contact, and a via extending adjacent to each of the first contact, the n-type source structure, the p-type source structure, and the second contact, wherein the first contact comprises titanium and nitrogen and the via comprises tungsten.

In one or more second embodiments, further to the first embodiments, the via is in contact with the first contact, and wherein the via comprises substantially pure tungsten.

In one or more third embodiments, further to the first or second embodiments, the second contact comprises tungsten.

In one or more fourth embodiments, further to the first through third embodiments, the via comprises tungsten, titanium, and nitrogen.

In one or more fifth embodiments, further to the first through fourth embodiments, wherein the first contact further comprises tungsten.

In one or more sixth embodiments, further to the first through fifth embodiments, the via comprises a greater proportion of titanium than the first contact.

In one or more seventh embodiments, further to the first through sixth embodiments, the via is in contact with the first contact and extends through an insulator material, and wherein the via comprises a first portion on a sidewall of the insulator material and a second portion on the first portion, the first portion comprising titanium and nitrogen and the second portion comprising tungsten.

In one or more eighth embodiments, further to the first through seventh embodiments, the second contact comprises nickel, platinum, and tungsten.

In one or more ninth embodiments, further to the first through eighth embodiments, the second contact has a thickness of not more 15 nm.

In one or more tenth embodiments, further to the first through ninth embodiments, the apparatus further comprises one or more frontside metallization layers over the first contact, and one or more backside metallization layers over the second contact, wherein the via couples the one or more backside metallization layers to the first contact.

In one or more eleventh embodiments, further to the first through tenth embodiments, an integrated circuit (IC) die comprises the complementary field effect transistor, the first contact, the second contact, and the via, the apparatus further comprising a power supply coupled to the IC die.

In one or more twelfth embodiments, a system comprises an IC die according to any of the apparatuses of the first through tenth embodiments, the system further comprising a power supply or display coupled to the IC die.

In one or more thirteenth embodiments, an apparatus comprises a complementary field effect transistor comprising one or more first semiconductor structures vertically aligned with one or more second semiconductor structures, an n-type source structure coupled to the first semiconductor structures, and a p-type source structure coupled to the second semiconductor structures, a first contact on the n-type source structure and a second contact on the p-type source structure, wherein the first contact is opposite the n-type source structure and the p-type source structure from the second contact, and a via extending adjacent to each of the first contact, the n-type source structure, the p-type source structure, and the second contact, wherein the first contact comprises titanium and nitrogen and the second contact comprises one of nickel or platinum.

In one or more fourteenth embodiments, further to the thirteenth embodiments, the second contact comprises nickel, platinum, and tungsten.

In one or more fifteenth embodiments, further to the thirteenth or fourteenth embodiments, the via is in contact with the first contact, and wherein the via comprises substantially pure tungsten or the via comprises tungsten, titanium, and nitrogen.

In one or more sixteenth embodiments, further to the thirteenth through fifteenth embodiments, an integrated circuit (IC) die comprises the complementary field effect transistor, the first contact, the second contact, and the via, the apparatus further comprising a power supply coupled to the IC die.

In one or more seventeenth embodiments, a system comprises an IC die according to any of the apparatuses of the thirteenth through fifteenth embodiments, the system further comprising a power supply or display coupled to the IC die.

In one or more eighteenth embodiments, a method comprises receiving a complementary field effect transistor comprising one or more first semiconductor structures vertically aligned with one or more second semiconductor structures, a first conductivity type source structure coupled to the first semiconductor structures, and a second conductivity type source structure coupled to the second semiconductor structures, forming a first contact on the first conductivity type source structure, exposing and removing a sacrificial material from the second conductivity type source structure, forming a second contact material on the second conductivity type source structure, and recessing the second contact material to form a second contact on the second conductivity type source structure.

In one or more nineteenth embodiments, further to the eighteenth embodiments, the method further comprises forming a via extending adjacent to each of the first contact, the first conductivity type source structure, the second conductivity type source structure, and the sacrificial material.

In one or more twentieth embodiments, further to the eighteenth or nineteenth embodiments, the first contact comprises titanium and nitrogen and the via comprises tungsten.

In one or more twenty-first embodiments, further to the eighteenth through twentieth embodiments, the via further comprises titanium and nitrogen.

In one or more twenty-second embodiments, further to the eighteenth through twenty-first embodiments, the second contact comprises tungsten and at least one of nickel or platinum.

It will be recognized that the invention is not limited to the embodiments so described but can be practiced with modification and alteration without departing from the scope of the appended claims. For example, the above embodiments may include specific combination of features. However, the above embodiments are not limited in this regard, and, in various implementations, the above embodiments may include the undertaking only a subset of such features, undertaking a different order of such features, undertaking a different combination of such features, and/or undertaking additional features than those features explicitly listed. The scope of the invention should, therefore, be determined with reference to the appended claims, along with the full scope of equivalents to which such claims are entitled.

## Claims

1. An apparatus, comprising:
a complementary field effect transistor comprising one or more first semiconductor structures vertically aligned with one or more second semiconductor structures, an n-type source structure coupled to the first semiconductor structures, and a p-type source structure coupled to the second semiconductor structures;
a first contact on the n-type source structure and a second contact on the p-type source structure, wherein the first contact is opposite the n-type source structure and the p-type source structure from the second contact; and
a via extending adjacent to each of the first contact, the n-type source structure, the p-type source structure, and the second contact, wherein the first contact comprises titanium and nitrogen and the via comprises tungsten.

2. The apparatus of claim 1, wherein the via is in contact with the first contact, and wherein the via comprises substantially pure tungsten.

3. The apparatus of claim 1, wherein the via comprises tungsten, titanium, and nitrogen.

4. The apparatus of any of claims 1 to 3, wherein the second contact comprises tungsten.

5. The apparatus of any of claims 1 to 4, wherein the first contact further comprises tungsten.

6. The apparatus of any of claims 2 to 5, wherein the via comprises a greater proportion of titanium than the first contact.

7. The apparatus of any of claims 2 to 6, wherein the via is in contact with the first contact and extends through an insulator material, and wherein the via comprises a first portion on a sidewall of the insulator material and a second portion on the first portion, the first portion comprising titanium and nitrogen and the second portion comprising tungsten.

8. The apparatus of any of claims 1 to 7, wherein the second contact comprises nickel, platinum, and tungsten.

9. The apparatus of any of claims 1 to 8, wherein the second contact has a thickness of not more 15 nm.

10. The apparatus of any of claims 1 to 9, further comprising:
one or more frontside metallization layers over the first contact; and
one or more backside metallization layers over the second contact, wherein the via couples the one or more backside metallization layers to the first contact.

11. The apparatus of any of claims 1 to 10, wherein an integrated circuit (IC) die comprises the complementary field effect transistor, the first contact, the second contact, and the via, the apparatus further comprising a power supply coupled to the IC die.

12. A method, comprising:
receiving a complementary field effect transistor comprising one or more first semiconductor structures vertically aligned with one or more second semiconductor structures, a first conductivity type source structure coupled to the first semiconductor structures, and a second conductivity type source structure coupled to the second semiconductor structures;
forming a first contact on the first conductivity type source structure;
exposing and removing a sacrificial material from the second conductivity type source structure;
forming a second contact material on the second conductivity type source structure; and
recessing the second contact material to form a second contact on the second conductivity type source structure.

13. The method of claim 12, further comprising
forming a via extending adjacent to each of the first contact, the first conductivity type source structure, the second conductivity type source structure, and the sacrificial material.

14. The method of claim 13, wherein the first contact comprises titanium and nitrogen and the via comprises tungsten.

15. The method of claim 14, wherein the via further comprises titanium and nitrogen and/or the second contact comprises tungsten and at least one of nickel or platinum.
